# DEMANDE DE BREVET EUROPEEN

(11) **EP 3 451 485 A1**
(43) Date de publication de la demande: **06.03.2019**
(21) Numéro de dépôt: 18184770.8
(22) Date de dépôt: 20.07.2018
(51) Int. Cl.: H02J 7/00, B60L 11/18, F25B 25/00

(54) **DISPOSITIF DE CONNEXION ÉLECTRIQUE POUR VÉHICULE AUTOMOBILE REFROIDI PAR UN CIRCUIT DE FLUIDE RÉFRIGÉRANT**

(30) Priorité: 29.08.2017 FR 1757950
(71) Demandeur: Valeo Systemes Thermiques, 78322 Le Mesnil Saint-Denis Cedex (FR)
(72) Inventeur: JOVET, Bastien, 78322 LE MESNIL SAINT DENIS CEDEX (FR); MARTINS, Carlos, 78322 LE MESNIL SAINT DENIS CEDEX (FR); CHARBONNELLE, François, 78322 LE MESNIL SAINT DENIS CEDEX (FR); BRIEND, Maël, 78322 LE MESNIL SAINT DENIS CEDEX (FR); JOUANNY, Philippe, 78322 LE MESNIL SAINT DENIS CEDEX (FR); SAAB, Samer, 78322 LE MESNIL SAINT-DENIS CEDEX (FR); DROULEZ, Eric, 78322 LE MESNIL SAINT DENIS CEDEX (FR)
(74) Mandataire: Tran, Chi-Hai

(57) **Abrégé**

Circuit (1001, 1002, 1003, 1004) d'un fluide réfrigérant (700) de véhicule (2) comprenant :
- un compresseur (200) destiné à élever la pression du fluide réfrigérant (700),
- un condenseur (300, 301), situé en aval du compresseur (200) selon un sens de circulation du fluide réfrigérant (700) dans le circuit (1001, 1002, 1003, 1004),
- un organe de détente (401, 402, 403, 404, 405), situé en aval du condenseur (300, 301), destiné à abaisser la pression du fluide réfrigérant (700),
- un évaporateur (600, 601), situé en aval de l'organe de détente (401, 402, 403, 404, 405),
caractérisé en ce qu'il comprend un échangeur de chaleur (900) dédié au refroidissement d'une prise de charge (12) située sur le véhicule et/ou de la connectique située sur le véhicule (2) reliant une source électrique et la batterie (3) à charger.

## Description

La présente invention se rapporte au domaine de la charge de batteries de véhicule automobile, et notamment des batteries de traction pour les véhicules automobiles de type hybride ou électrique. Par batteries de traction, il est entendu tout dispositif de stockage d'énergie permettant de générer une force motrice du véhicule automobile. L'invention a pour objet l'échangeur de chaleur destiné au refroidissement du dispositif de connexion électrique, situé sur le véhicule, permettant la charge de telles batteries, ainsi que le circuit de refroidissement associé.

La charge d'une batterie de traction peut se faire par branchement électrique. Une première façon de charger la batterie, appelée de charge rapide, est mise en oeuvre par des bornes dédiées, qui sont configurées pour délivrer du courant continu par exemple. Pour cela, un cordon de charge relié à la borne est équipé d'un connecteur de type pistolet à brancher sur la prise de charge du véhicule. Par exemple en délivrant un courant continu de 120 Ampères, ce type de borne permet de charger complètement la batterie de traction entre 20 et 30 minutes. Généralement, une telle borne de charge rapide est agencée pour délivrer 350 kilowatts.

Une deuxième façon de charger la batterie, dite de charge normale, est mise en oeuvre par un branchement sur une prise de réseau électrique domestique. Pour cela, un cordon de charge comprenant à sa première extrémité un connecteur de type secteur et à sa seconde extrémité un connecteur de type pistolet, est destiné à être branché sur la prise de charge du véhicule. Le cordon de charge comprend aussi un boîtier de transformation situé entre les deux extrémités. Ce type de charge, nécessite généralement 8h à 12h de branchement pour une charge complète de la batterie de traction.

Une troisième façon de charger la batterie, dite de récupération, est mise en oeuvre lors des phases de freinage et de décélération. En effet, lors d'une phase de freinage ou de décélération, les roues du véhicule automobile entraînent le moteur électrique du véhicule automobile selon un sens de rotation permettant de créer un courant électrique, dit de récupération, utilisé pour la charge de la batterie de traction. Cette façon de charger la batterie de traction n'utilise qu'une des trois phases du moteur, le rendement de charge est donc assez faible.

Un inconvénient bien connu de la charge, qu'elle soit de type charge rapide, charge normale, est que la connexion entre la source électrique et la batterie à charger du véhicule dégage une puissance thermique importante. Or, l'échauffement de ces éléments provoque une réduction de la puissance électrique transmise à la batterie, notamment lorsqu'une température seuil est atteinte. Ainsi, lorsque l'échauffement atteint cette température seuil, la durée de charge de la batterie se trouve allongée par rapport aux valeurs théoriques basées exclusivement sur le transfert de la puissance électrique. Or, compte tenu des besoins du marché, cet allongement de la durée de charge représente un inconvénient à surmonter, en particulier dans le cas de la charge rapide.

Pour cela, l'art antérieur propose des solutions pour refroidir la borne de charge et/ou le cordon de charge. Par exemple, le document EP0823767 se propose de fournir un cordon de charge comprenant un canal de fluide de refroidissement alimenté en fluide de refroidissement provenant de la borne de charge.

Toutefois, l'art antérieur ne semble pas proposer de solution visant à refroidir la prise de charge située sur le véhicule et/ou la connectique reliant la prise de charge située sur le véhicule et la batterie à charger.

Dans ce contexte la présente invention a pour objet un circuit d'un fluide réfrigérant de véhicule comprenant :
- un compresseur (200) destiné à élever la pression du fluide réfrigérant (700),
- un condenseur (300, 301), situé en aval du compresseur (200) selon un sens de circulation du fluide réfrigérant (700) dans le circuit (1001, 1002, 1003, 1004),
- un organe de détente (401, 402, 403, 404, 405), situé en aval du condenseur (300, 301), destiné à abaisser la pression du fluide réfrigérant (700),
- un évaporateur (600, 601), situé en aval de l'organe de détente (401, 402, 403, 404, 405),
caractérisé en ce qu'il comprend un échangeur de chaleur (900) dédié au refroidissement d'une prise de charge (12) située sur le véhicule et/ou de la connectique située sur le véhicule (2) reliant une source électrique et la batterie (3) à charger.

Un tel circuit permet d'une part de chauffer et/ou de climatiser un habitacle de véhicule automobile et d'autre part de refroidir le dispositif de connexion à l'aide de l'échangeur de chaleur qui lui est dédié. Ce circuit est particulièrement avantageux, dans le sens où l'échangeur de chaleur dédié au refroidissement d'une prise de charge située sur le véhicule et/ou de la connectique située sur le véhicule reliant une source électrique et la batterie à charger peut être directement intégré sur un circuit de fluide réfrigérant déjà existant sur le véhicule.

L'échangeur de chaleur dédié au refroidissement du dispositif de connexion électrique permet le refroidissement de la connexion entre une source électrique et la batterie à charger du véhicule. Plus précisément, ce refroidissement permet de rester en dessous de la température seuil, évitant ainsi d'endommager des composants du dispositif de connexion qui entourent les conducteurs électriques. In fine, l'invention assure une amélioration du transfert de la puissance électrique vers la batterie et par conséquent une diminution du temps de charge.

L'invention apporte ainsi une solution respectant les besoins du marché en proposant un échangeur de chaleur visant à refroidir par exemple la prise de charge située sur le véhicule et/ou la connectique située sur le véhicule reliant une source électrique et la batterie à charger.

Selon une ou plusieurs caractéristiques de l'invention pouvant être prise seule(s) ou en combinaison, on pourra prévoir que :
- l'échangeur de chaleur dédié au refroidissement du dispositif de connexion électrique est configuré pour réaliser un échange thermique entre le fluide réfrigérant et le dispositif de connexion électrique. On comprend alors que l'échangeur de chaleur dédié au refroidissement du dispositif de connexion électrique autorise un échange de calories entre le dispositif de connexion électrique et le fluide réfrigérant. Pour cela, l'échangeur de chaleur dédié au refroidissement du dispositif de connexion électrique interagit d'une part avec des composants du dispositif de connexion électrique et d'autre part avec le fluide réfrigérant en autorisant une circulation de ce fluide. Plus précisément, l'échangeur de chaleur dédié au refroidissement du dispositif de connexion électrique comprend au moins un conduit dans lequel le fluide réfrigérant circule.

Il est à noter qu'un fluide réfrigérant est défini comme un fluide autorisant des échanges de calories lors de ses changements de phases (liquide, vapeur, gaz...). Autrement dit, un fluide réfrigérant est un fluide qui présente des particularités physiques permettant de l'exploiter dans un cycle de compression/détente pour transférer des calories.

Plus particulièrement, les fluides réfrigérants sont choisis pour leurs températures de passage de l'état liquide à l'état gazeux, la quantité d'énergie nécessaire pour provoquer ce changement d'état et la différence de température provoquée par ce changement d'état.

À titre d'exemple, un tel fluide réfrigérant est connu sous l'acronyme R-134A, 1234YF ou encore R744.
- L'échangeur de chaleur est destiné à être situé au plus près du dispositif de connexion électrique. Par les termes « au plus près », il est entendu que l'échangeur de chaleur dédié au refroidissement du dispositif de connexion électrique est situé à une distance suffisamment proche, ou au contact, pour réaliser l'échange de chaleur avec le dispositif de connexion électrique.
- Le dispositif de connexion comprend au moins un conducteur électrique destiné à assurer une liaison électrique vers la batterie.
- Le dispositif de connexion comprend une prise de charge présentant au moins un terminal électrique en contact électrique avec l'au moins un conducteur électrique.
- Le dispositif de connexion comprend un câble de charge s'étendant à partir de la prise de charge et jusqu'à la batterie et comprenant l'au moins un conducteur électrique.
- La batterie est une batterie de traction.
- L'échangeur de chaleur dédié au refroidissement du dispositif de connexion électrique est disposé entre le condenseur et le compresseur du circuit.
- Le circuit comprend une branche de refroidissement qui comporte l'échangeur de chaleur dédié au refroidissement du dispositif de connexion électrique, ladite branche de refroidissement s'étendant dans une portion basse pression connectée au condenseur et au compresseur. Ainsi, en sortie du condenseur, on s'assure que le fluide réfrigérant est à basse température, ce qui permet d'assurer le transfert de calories. La branche de refroidissement est ainsi disposée côté basse pression du circuit de fluide réfrigérant.
- La branche de refroidissement s'étend en parallèle d'une branche de climatisation comportant l'évaporateur, depuis un premier noeud formé entre la branche de climatisation et la branche de sortie du condenseur et un deuxième noeud formé entre la branche de climatisation et la branche d'entrée du compresseur.
- La branche de refroidissement comprend une vanne de contrôle du débit située entre le condenseur et l'échangeur de chaleur dédié au refroidissement du dispositif de connexion électrique. Une telle vanne de contrôle du débit permet de contrôler la circulation du fluide réfrigérant dans la branche de refroidissement.
- La branche de refroidissement s'étend en parallèle d'une branche dite de climatisation comprenant l'évaporateur. Ainsi, la branche de refroidissement peut être alimentée en fluide réfrigérant indépendamment de la branche de climatisation et vice versa. Il peut également être prévu d'alimenter les deux branches simultanément. Dans ce cas un élément régulant les débits dans ces branches peut être prévu.
- La branche de refroidissement comprend un organe de détente, dit deuxième organe de détente, situé entre le condenseur et l'échangeur de chaleur dédié au refroidissement du dispositif de connexion électrique. En d'autres termes, le deuxième organe de détente est situé en aval du condenseur et en amont de l'échangeur de chaleur dédié au refroidissement du dispositif de connexion électrique, selon un sens de circulation du fluide réfrigérant dans la branche de refroidissement. Un tel organe de détente permet d'abaisser la pression du fluide réfrigérant, ce qui a pour conséquence d'abaisser sa température. Ainsi, le fluide réfrigérant circulant dans l'échangeur de chaleur dédié au refroidissement du dispositif de connexion électrique est à basse température, cet échangeur de chaleur dédié au refroidissement du dispositif de connexion électrique se comportant alors comme un évaporateur pour le fluide réfrigérant.
- La vanne de contrôle du débit est par exemple située en amont du deuxième organe de détente, selon un sens de circulation du fluide réfrigérant dans la branche de refroidissement.
- Le circuit comprend un deuxième échangeur de chaleur destiné à un refroidissement d'une batterie de traction du véhicule. Ainsi, le circuit permet de refroidir d'une part la batterie de traction et d'autre part le dispositif de connexion électrique.
- Le circuit comprend une branche de traitement thermique comportant le deuxième échangeur de chaleur, ladite branche de traitement thermique étant disposée en parallèle de la branche de refroidissement. En d'autres termes, l'échangeur de chaleur dédié au refroidissement du dispositif de connexion électrique et le deuxième échangeur de chaleur sont disposés en parallèle. Cette réalisation du circuit permet d'alimenter sélectivement le premier échangeur de chaleur ou le deuxième échangeur de chaleur, notamment lorsqu'au moins une vanne de contrôle du débit est prévue.
- Le circuit comprend une branche de traitement thermique comportant le deuxième échangeur de chaleur, la branche de refroidissement formant une dérivation de ladite branche de traitement thermique. Une telle dérivation présente l'avantage de pouvoir s'adapter sur des circuits déjà existant. Ainsi, la fabrication d'un tel circuit s'en retrouve facilitée.
- La branche de traitement thermique comprend une vanne de contrôle du débit située entre le condenseur et le deuxième échangeur de chaleur.
- La branche de traitement thermique comprend un organe de détente situé entre le condenseur et le deuxième échangeur de chaleur.
- L'échangeur de chaleur dédié au refroidissement du dispositif de connexion est disposé en série du deuxième échangeur de chaleur sur la branche de refroidissement. On comprend alors que le dispositif de connexion est nécessairement refroidi lors du refroidissement de la batterie et inversement.
- Selon un exemple, l'échangeur de chaleur dédié au refroidissement du dispositif de connexion est disposé en aval du deuxième échangeur de chaleur, selon un sens de circulation du fluide réfrigérant dans la branche de refroidissement. Ainsi, le fluide réfrigérant refroidi en premier lieu la batterie puis le dispositif de connexion.

Cette réalisation présente l'avantage d'utiliser une même vanne de contrôle du débit et/ou un même organe de détente pour le refroidissement de la batterie et du dispositif de connexion.

Un autre avantage de cette réalisation réside dans l'optimisation de la durée de vie du compresseur. En effet, lors de la charge de la batterie, la température moyenne du dispositif de connexion électrique est nettement supérieure à la température moyenne de la batterie. Par conséquent, placer le refroidissement du dispositif de connexion électrique en aval du refroidissement de la batterie permet de réaliser une surchauffe du fluide réfrigérant et donc de maximiser la part gazeuse du fluide réfrigérant se dirigeant vers le compresseur. De plus, cela permet d'améliorer l'efficacité du deuxième échangeur de chaleur en s'assurant que le fluide réfrigérant circulant en son sein soit exclusivement ou quasiment exclusivement sous forme liquide.
- Le circuit est destiné à coopérer avec une installation de ventilation, de chauffage et/ou de climatisation dans laquelle est disposé le condenseur et/ou l'évaporateur.
- Le circuit comprend un échangeur thermique utilisable en tant qu'évaporateur ou condenseur. De préférence, cet échangeur thermique est destiné à être disposé en face avant du véhicule.

D'autres caractéristiques, détails et avantages de l'invention et de son fonctionnement ressortiront plus clairement à la lecture de la description donnée ci-après à titre indicatif, en relation avec les figures annexées, dans lesquelles :
- la figure 1 est une représentation schématique d'un véhicule automobile comprenant un dispositif de connexion électrique selon la présente invention pour la charge d'une batterie, le véhicule automobile étant relié à une source électrique externe,
- la figure 2 est une représentation schématique d'un premier exemple de réalisation d'un circuit de fluide réfrigérant, selon la présente invention, équipé d'une branche de refroidissement comprenant un échangeur de chaleur dédié au refroidissement du dispositif de connexion électrique équipant le véhicule automobile,
- la figure 3 est une représentation schématique d'un deuxième exemple de réalisation d'un circuit de fluide réfrigérant, selon la présente invention,
- la figure 4 est une représentation schématique d'un troisième exemple de réalisation d'un circuit de fluide réfrigérant, selon la présente invention,
- la figure 5 est une représentation schématique d'un quatrième exemple de réalisation d'un circuit de fluide réfrigérant, selon la présente invention.

Il est tout d'abord à noter que si les figures exposent l'invention de manière détaillée pour sa mise en oeuvre, elles peuvent bien entendu servir à mieux définir l'invention le cas échéant. De même, il est rappelé que, pour l'ensemble des figures, les mêmes éléments sont désignés par les mêmes repères.

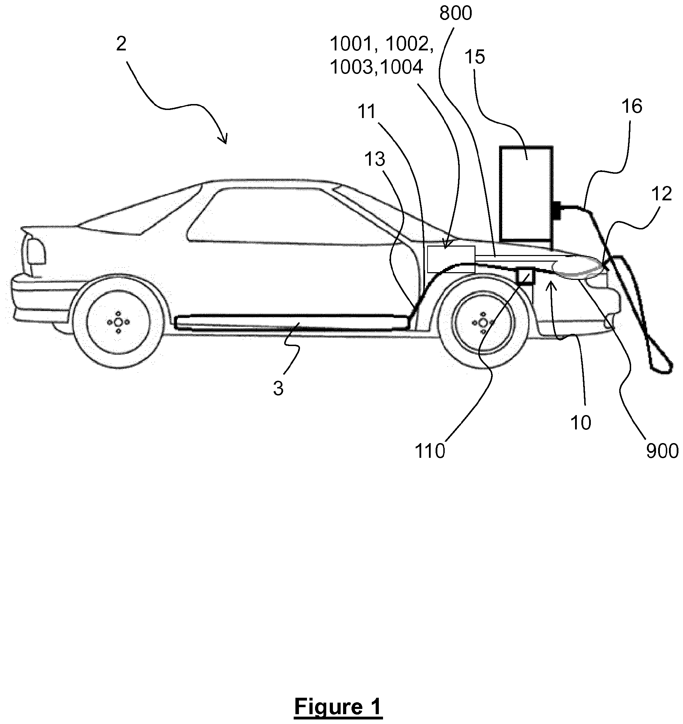

La figure 1 montre un véhicule automobile 2, par exemple de type tout électrique ou hybride, branché à une source électrique 15, afin de recharger une batterie. Selon cet exemple de réalisation, la source électrique 15 permet de recharger une batterie de traction 3 du véhicule automobile 2. Par batteries de traction, il est entendu tout dispositif de stockage d'énergie permettant de générer une force motrice du véhicule automobile. Pour transférer l'électricité fournie par la source électrique 15 vers le véhicule automobile 2, et notamment vers la batterie de traction 3, celui-ci comprend un dispositif de connexion électrique 10.

La source électrique 15 est ici une borne de charge rapide délivrant sensiblement 350 kilowatts (kW). Bien entendu, la source électrique 15 pourrait aussi être une prise de réseau électrique domestique permettant une charge normale de la batterie de traction 3 ou encore un système de récupération d'énergie lors du freinage ou de la décélération du véhicule.

Plus précisément, le dispositif de connexion électrique 10 fait partie intégrante du véhicule automobile 2. On entend par là que le dispositif de connexion électrique 10 est situé sur le véhicule 2, c'est-à-dire que même en condition de roulage, le dispositif de connexion électrique 10 fait partie du véhicule 2.

Le dispositif de connexion électrique 10 comprend une prise de charge 12 située sur une partie accessible du véhicule 2, et sur laquelle un usager peut brancher un cordon de charge 16 électriquement connecté à la source électrique 15. La prise de charge 12 permet de relier la batterie de traction 3 du véhicule à charger au cordon de charge 16, électriquement connecté à la source électrique 15, le cordon de charge 16 ne faisant pas partie du dispositif de connexion électrique 10.

Afin de charger la batterie de traction 3, la prise de charge 12 est électriquement reliée à la batterie de traction 3. Pour cela, le dispositif de connexion électrique 10 comprend au moins un câble de charge 13 s'étendant entre la batterie de traction 3 et la prise de charge 12. Il est à noter que pour assurer une liaison électrique entre ces différents éléments, le dispositif de connexion électrique 10 comprend au moins un conducteur électrique 11 s'étendant entre la prise de charge 12 et la batterie de traction 3. Le conducteur électrique 11 est présent dans la prise de charge 12, sous forme de terminaux électriques, puis se poursuit en prenant la forme du câble de charge 13, jusqu'à la batterie de traction 3. Un tel conducteur électrique 11 permet de transférer l'énergie électrique vers la batterie de traction 3. Plus précisément, le conducteur électrique 11 comprend une première partie destinée à être reliée à la borne positive de la source électrique 15, via un des terminaux électriques, et une deuxième partie destinée à être reliée à la borne négative de la source électrique 15, via un autre des terminaux électriques.

Par ailleurs, il peut être prévu que le dispositif de connexion électrique 10 comprenne un boîtier de transformation 110 pour traiter le courant électrique se dirigeant vers la batterie de traction 3.

Afin de refroidir le dispositif de connexion électrique 10 durant la charge de la batterie de traction 3, le dispositif de connexion électrique 10 peut être équipé d'un échangeur de chaleur destiné à coopérer avec une source de refroidissement issue du véhicule automobile 2. Plus précisément, selon la présente invention, la source de refroidissement correspond à un circuit 1001, 1002, 1003, 1004 de fluide réfrigérant qui collabore avec une installation de ventilation, de chauffage, et/ou de climatisation d'un habitacle du véhicule automobile 2.

Pour cela, et comme cela sera décrit plus loin, le circuit 1001, 1002, 1003, 1004 comprend une branche de refroidissement 800 destinée à être alimentée en fluide réfrigérant 700. Plus précisément, cette branche de refroidissement 800, destinée à être traversée par un fluide réfrigérant 700, comprend un échangeur de chaleur 900 dédié au refroidissement du dispositif de connexion électrique 10. On comprend alors que l'échangeur de chaleur 900 dédié au refroidissement du dispositif de connexion électrique 10 forme une interface entre le dispositif de connexion électrique 10 et le circuit de fluide réfrigérant. De préférence, l'échangeur de chaleur 900 dédié au refroidissement du dispositif de connexion électrique 10 se présente sous la forme d'une canalisation thermiquement conductrice, dans laquelle le fluide réfrigérant 700 est destiné à circuler à basse température.

Plus particulièrement, l'échangeur de chaleur 900 dédié au refroidissement du dispositif de connexion électrique 10 est dédié au refroidissement partiel ou total du dispositif de connexion électrique 10. À cet effet, l'échangeur de chaleur 900 dédié au refroidissement du dispositif de connexion électrique 10 peut se présenter sous diverses formes.

Selon un premier exemple de réalisation et afin de refroidir la prise de charge 12 du dispositif de connexion électrique 10, la canalisation thermiquement conductrice s'étend autour, à l'intérieur ou le long de la prise de charge 12 uniquement. De préférence, la canalisation thermiquement conductrice s'étend au plus près des terminaux électriques de la prise de charge 12. Par au plus près, on entend de manière suffisamment proche pour qu'il y ait échange thermique entre l'échangeur de chaleur 900 dédié au refroidissement du dispositif de connexion électrique 10 et les terminaux électriques.

On comprend que la canalisation thermiquement conductrice fait partie intégrante du dispositif de connexion électrique 10, notamment par le biais de l'échangeur de chaleur 900 dédié au refroidissement du dispositif de connexion électrique 10. Dans ce cas, la canalisation thermiquement conductrice est bien destinée à coopérer avec le circuit 1001, 1002, 1003, 1004 de fluide réfrigérant 700.

Selon un deuxième exemple de réalisation et afin de refroidir le câble de charge 13 du dispositif de connexion électrique 10, la canalisation thermiquement conductrice s'étend le long, autour ou à l'intérieur du câble de charge 13, uniquement et au plus près de celui-ci. Par au plus près, on entend de manière suffisamment proche pour qu'il y ait échange thermique entre l'échangeur de chaleur 900 dédié au refroidissement du dispositif de connexion électrique 10 et les terminaux électriques.

Selon un troisième exemple de réalisation, dans lequel la totalité du dispositif de connexion électrique 10 est refroidie, la canalisation thermiquement conductrice s'étend le long, autour, et/ou à l'intérieur du câble de charge 13, autour, à l'intérieur et/ou le long de la prise de charge 12. Il peut également être prévu de refroidir le boîtier de transformation 110.

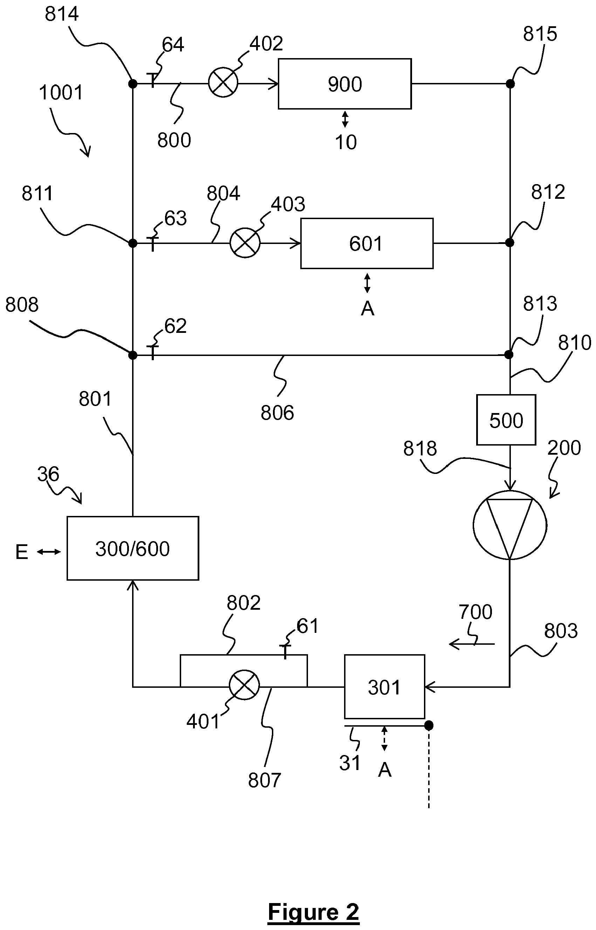

Plusieurs exemples de réalisation du circuit de fluide réfrigérant 700 vont maintenant être décrits en relation avec les figures 2 à 5. Toutefois il est à noter que pour l'ensemble de ces exemples de réalisation, chacun des circuits 1001, 1002, 1003, 1004 comprend un compresseur 200, au moins un condenseur 300, 301, au moins un organe de détente 401, 402, 403, au moins un évaporateur interne 601 et un échangeur de chaleur 900 dédié au refroidissement du dispositif de connexion électrique 10. Le fluide réfrigérant 700 circule successivement à travers ces éléments en formant un circuit fermé. Par ailleurs, dans ce qui suit, les dénominations amont et aval seront utilisées en référence au sens d'écoulement du fluide réfrigérant au sein du circuit 1001, 1002, 1003, 1004.

Ainsi, comme cela est visible sur les exemples de réalisation montrés en figures 2 à 5, le compresseur 200 est relié à un condenseur interne 301 par une branche 803 dans laquelle le fluide réfrigérant 700 circule à haute pression, et donc à haute température. Ce condenseur interne 301 est situé dans l'installation de ventilation, de chauffage et/ou de climatisation et est sélectivement traversé par un flux d'air A ou non, à l'aide d'un dispositif d'obturation 31. Il est à noter que la dénomination « interne » désigne un élément situé à l'intérieur de l'installation de ventilation, de chauffage et/ou de climatisation.

Lorsque le condenseur interne 301 est traversé par le flux d'air A, le fluide réfrigérant 700 échange des calories avec ce flux d'air A et se retrouve dans un état différent en sortie de ce condenseur interne 301. Lorsque le dispositif d'obturation 31 empêche le flux d'air A de traverser le condenseur interne 301, le fluide réfrigérant 700 n'échange pas de calories et ne change pas d'état lors de sa traversée du condenseur interne 301.

En sortie de ce condenseur interne 301 et en fonction de l'état du fluide réfrigérant 700, le fluide réfrigérant traverse une branche 802 sur laquelle se situe une vanne de contrôle du débit 61, appelée première vanne 61, ou une branche 807 sur laquelle est disposé un organe de détente, appelé premier organe de détente 401.

En sortie de ces deux branches 802, 807 le fluide réfrigérant 700 est dirigé vers un échangeur thermique 36 utilisable en tant que condenseur 300 ou évaporateur 600, en fonction de l'état du fluide réfrigérant 700. Cet échangeur thermique 36 est situé en face avant du véhicule automobile 2, de manière à être exposé à un flux d'air extérieur E. En sortie de cet échangeur thermique 36, le fluide réfrigérant 700 emprunte une branche 801 jusqu'à une bifurcation 808.

À l'issue de cette bifurcation 808, le fluide réfrigérant 700 est destiné à emprunter une ou plusieurs branches disposées en parallèle avant d'atteindre de nouveau le compresseur 200. Parmi ces branches disposées en parallèle, on distingue une première branche 806, appelée branche retour 806, sur laquelle seule une vanne de contrôle du débit, appelée deuxième vanne de contrôle du débit 62, est disposée, et une deuxième branche 804, dite de climatisation, sur laquelle au moins un évaporateur interne 601 est prévu.

L'évaporateur interne 601 est situé dans l'installation de ventilation, de chauffage et/ou de climatisation et est exposé à un flux d'air A. La branche de climatisation 804 forme un premier noeud 811 avec la branche 801 sortant de l'échangeur thermique 36 et un deuxième noeud 812 avec une branche 810 menant vers un accumulateur 500.

Il est à préciser que la branche retour 806 prend naissance à la bifurcation 808 et forme un noeud, appelé troisième noeud 813, avec une branche 810 menant vers un accumulateur 500.

Selon une partie des exemples de circuit qui vont être décrits ci-dessous, parmi ces branches disposées en parallèle, on distingue également une branche de refroidissement 800 sur laquelle au moins un échangeur de chaleur 900 dédié au refroidissement du dispositif de connexion électrique 10 est prévu. Il est à préciser que la branche de refroidissement 800 forme un noeud, appelé quatrième noeud 814, avec la branche 801 sortant de l'échangeur thermique 36 et un autre noeud, appelé cinquième noeud 815, avec la branche 810 menant vers l'accumulateur 500

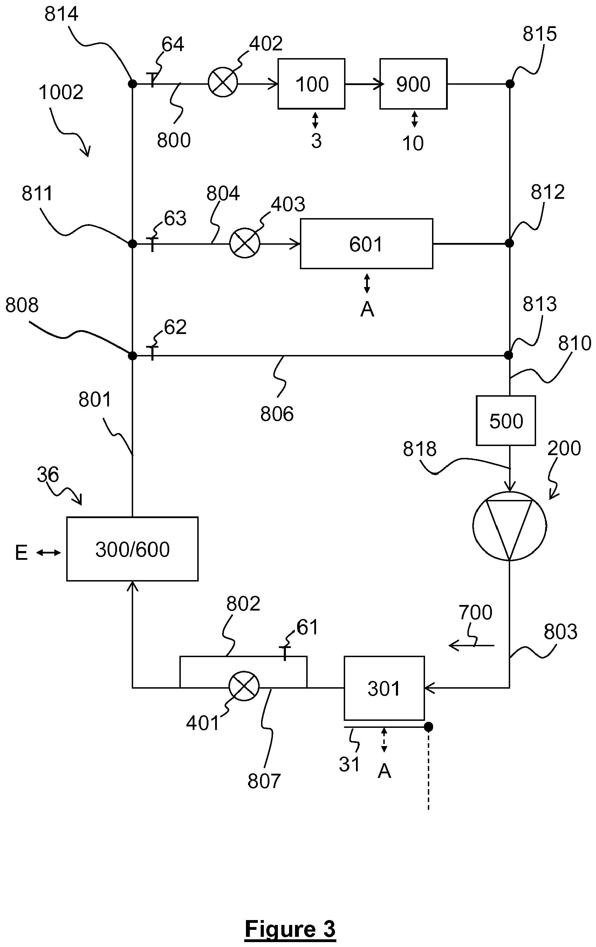

Selon d'autres exemples de circuit montrés sur les figures 3 à 5, parmi ces branches disposées en parallèle, on distingue aussi une branche 850, dite additionnelle, dédiée au refroidissement de la batterie de traction 3, sur laquelle au moins un échangeur de chaleur 100 dédié au refroidissement de la batterie de traction 3 est prévu.

En sortie de ces différentes branches 800, 804, 806, 850, le fluide réfrigérant 700 est acheminé dans une branche 810 menant vers un accumulateur 500. Cet accumulateur 500 permet de s'assurer que seule la phase gazeuse du fluide réfrigérant 700 se dirige vers le compresseur 200, via une branche 818 reliant l'accumulateur 500 au compresseur 200. Il est à noter que le fluide réfrigérant 700 circulant dans la branche 810 terminant le circuit est à basse pression. La branche 810 et la branche 818, située en aval de la branche 810 et en amont du compresseur 200, pourront être désignées par les termes « branche basse pression » du circuit.

Il est à noter que pour l'ensemble des circuits 1001, 1002, 1003, 1004 qui vont être décrits, le fluide réfrigérant 700, en sortie de l'échangeur de chaleur 900 dédié au refroidissement du dispositif de connexion électrique 10, est toujours dirigé vers le compresseur 200. Pour cela, la branche de refroidissement 800 du dispositif de connexion électrique 10 s'étend depuis l'échangeur thermique 36 et jusqu'au compresseur 200. Plus précisément, la branche de refroidissement 800 s'étend en parallèle de la branche 804 comportant l'évaporateur interne 601, depuis le premier noeud 811 vers le deuxième noeud 812.

Dans tous les cas de circuits 1001, 1002, 1003, 1004 qui vont être décrits, le fluide réfrigérant 700 est admis sous forme essentiellement gazeuse au sein du compresseur 200. À la sortie du compresseur 200, le fluide réfrigérant 700, qui a subi une compression, se présente sous la forme d'un gaz dont la pression et la température ont augmentées.

La figure 2 représente de manière schématique un premier exemple de réalisation d'un circuit 1001 de fluide réfrigérant 700, qui collabore avec une installation de ventilation, de chauffage, et/ou de climatisation d'un habitacle de véhicule automobile.

Selon un premier mode de fonctionnement dit de climatisation, le fluide réfrigérant 700, en sortie du compresseur 200, est admis dans un échangeur thermique 36 pouvant aussi bien être utilisé comme un condenseur 300 ou comme un évaporateur 600, selon l'état dans lequel le fluide réfrigérant 700 circulant au sein de cet échangeur thermique 36. Le fluide réfrigérant 700 étant dans cet exemple sous forme gazeuse, cet échangeur thermique 36 se comporte comme un condenseur 300, dans lequel il subit un premier changement de phase et se transforme en liquide. Lors de ce changement de phase, la pression du fluide réfrigérant 700 reste constante et sa température diminue, le fluide réfrigérant 700 cédant une partie de sa chaleur à un flux d'air extérieur E par le biais du condenseur 300.

Il est à noter que le circuit 1001 comprend un condenseur interne 301, qui dans ce mode de fonctionnement en climatisation, n'est pas utilisé. En effet, on peut voir que le dispositif d'obturation 31, tel qu'un volet, est en position fermée de manière à interdire tout échange avec un flux d'air A traversant l'installation de ventilation, de chauffage, et/ou de climatisation. Par conséquent, le fluide réfrigérant 700 traverse ce condenseur interne 301 sans subir de transformation. De plus, le premier organe de détente 401 situé sur la branche 807, en sortie de ce condenseur interne 301 n'est pas utilisé dans ce mode de fonctionnement en climatisation et le fluide réfrigérant 700 emprunte la branche 802 pour atteindre l'échangeur thermique 36 fonctionnant en condenseur 300.

Selon un premier exemple de mise en oeuvre, une partie du fluide réfrigérant 700 est acheminé vers la branche 804 supportant l'évaporateur interne 601 et une autre partie vers la branche de refroidissement 800. Le fluide réfrigérant 700, essentiellement sous forme liquide à la sortie du condenseur 300, est alors acheminé vers un organe de détente 402, appelé deuxième organe de détente 402, situé sur la branche de refroidissement 800 et un organe de détente 403, appelé troisième organe de détente 403, situé sur la branche de climatisation 804 supportant l'évaporateur interne 601. La détente mise en oeuvre par les organes de détente 401, 402, 403 permet d'abaisser la pression du fluide réfrigérant 700, ce qui a pour résultat l'obtention d'un fluide réfrigérant 700 à l'état liquide et à basse température.

La disposition des organes de détente 402, 403 sur chacune des branches 800, 804, c'est-à-dire avec le deuxième organe de détente 402 situé sur la branche de refroidissement 800 et le troisième organe de détente 403 situé sur la branche de climatisation 804, permet d'éviter des pertes d'échange thermique en réduisant la distance parcourue par le fluide réfrigérant 700 à basse température avant d'atteindre l'évaporateur interne 601 ou l'échangeur de chaleur 900 dédié au refroidissement du dispositif de connexion électrique 10. Alternativement, on peut prévoir un unique organe de détente situé sur une portion de la branche 801, en sortie de l'échangeur thermique 36 et en amont de la bifurcation 808 répartissant le fluide réfrigérant vers les différentes branches parallèles 800, 804, 806 du circuit 1001 précédemment décrites.

Il est notable que selon le mode de fonctionnement en climatisation la branche retour 806, n'est pas utilisée, ainsi la deuxième vanne de contrôle du débit 62 située sur cette branche retour 806 est en position fermée de manière à interdire tout passage de fluide réfrigérant 700, liquide, vers le compresseur 200.

La partie du fluide réfrigérant 700 acheminée vers l'évaporateur interne 601 échange des calories avec un flux d'air A traversant l'évaporateur interne 601. Ce flux d'air A, circulant dans l'installation de ventilation, de chauffage et/ou de climatisation, se retrouve refroidi et est envoyé vers l'habitacle du véhicule.

La partie du fluide réfrigérant 700 acheminée vers la branche de refroidissement 800 est acheminée vers l'échangeur de chaleur 900 dédié au refroidissement du dispositif de connexion électrique 10 précédemment décrit et échange des calories avec une partie du dispositif de connexion électrique 10 ou la totalité du dispositif de connexion électrique 10, selon la forme que prend l'échangeur de chaleur 900 dédié au refroidissement du dispositif de connexion électrique 10.

On comprend de ce premier exemple de mise en oeuvre, que l'habitacle du véhicule automobile 2 est climatisé durant le refroidissement du dispositif de connexion électrique 10. Ainsi, lors de la charge de la batterie de traction 3 par une source électrique 15 fixe, un tel exemple de mise en oeuvre autorise également un préconditionnement de l'habitacle du véhicule automobile 2, c'est-à-dire avant que l'usager ne l'utilise. Il est à noter que la consommation électrique due au fonctionnement d'un tel circuit 1001 de fluide réfrigérant 700 est négligeable par rapport au gain de puissance que permet le refroidissement du dispositif de connexion électrique 10.

Selon un deuxième exemple de mise en oeuvre, une vanne de contrôle du débit, appelée troisième vanne de contrôle du débit 63, est disposée sur la branche de climatisation 804, en amont de l'évaporateur interne 601 selon le sens de circulation du fluide réfrigérant 700 dans la branche de climatisation 804. Lorsque cette troisième vanne de contrôle du débit 63 est en position fermée, elle permet d'acheminer la totalité du fluide réfrigérant 700 vers la branche de refroidissement 800. Ainsi, la totalité du fluide réfrigérant 700 est utilisée pour échanger des calories avec une partie ou la totalité du dispositif de connexion électrique 10, selon la forme que prend l'échangeur de chaleur 900 dédié au refroidissement du dispositif de connexion électrique 10.

Il est à noter que la troisième vanne de contrôle du débit 63 est située en amont du troisième organe de détente 403 situé sur la branche de climatisation 804, l'amont étant entendu selon le sens de circulation du fluide réfrigérant 700 dans la branche de climatisation 804. Toutefois, que la troisième vanne de contrôle du débit 63 soit située en amont ou en aval du troisième organe de détente 403, il est à noter qu'elle permet d'éviter la détente du fluide réfrigérant 700 lorsqu'elle est dans une position interdisant la circulation du fluide réfrigérant 700 dans la branche de climatisation 804.

Ainsi, ce deuxième exemple de mise en oeuvre, permet de ne pas climatiser l'habitacle du véhicule automobile 2 durant le refroidissement du dispositif de connexion électrique 10, ce qui permet de dédier la puissance calorifique du circuit 1001 au refroidissement du dispositif de connexion électrique 10.

Par ailleurs, il est notable que, la branche de refroidissement 800 est également équipée d'une vanne de contrôle du débit, appelée quatrième vanne de de contrôle du débit 64 permettant de désactiver le refroidissement du dispositif de connexion électrique 10. En effet, durant le roulage du véhicule automobile 2, ou durant une phase de démarrage, il n'est pas nécessaire de refroidir le dispositif de connexion électrique 10.

Il est à noter que la quatrième vanne de contrôle du débit 64 est située en amont du deuxième organe de détente 402 situé sur la branche de refroidissement 800, selon le sens de circulation du fluide réfrigérant 700 dans la branche de refroidissement 800. De la même manière que précédemment, que la quatrième vanne de contrôle du débit 64 soit située en amont ou en aval du deuxième organe de détente 402, il est à noter qu'elle permet d'éviter la détente du fluide réfrigérant 700 lorsqu'elle est dans une position interdisant la circulation du fluide réfrigérant 700 dans la branche de refroidissement 800.

Durant les échanges de calories, que ce soit dans l'évaporateur interne 601 ou dans l'échangeur de chaleur 900 dédié au refroidissement du dispositif de connexion électrique 10, le fluide réfrigérant 700 subit un nouveau changement de phase en se transformant en gaz. Il est ensuite réacheminé vers le compresseur 200 pour subir un nouveau cycle.

Afin de s'assurer que le compresseur 200 comprime du fluide réfrigérant 700 sous forme exclusivement gazeuse, le circuit 1001 est avantageusement équipé d'un accumulateur 500 situé directement en amont du compresseur 200. En d'autres termes, un accumulateur 500 peut être prévu sur le circuit 1001 entre l'évaporateur interne 601 et le compresseur 200 ou entre l'échangeur de chaleur 900 dédié au refroidissement du dispositif de connexion électrique 10 et le compresseur 200, de manière à ce que le compresseur 200 ne comprime que du fluide réfrigérant 700 sous forme exclusivement gazeuse.

Selon un deuxième mode de fonctionnement dit de pompe à chaleur, le fluide réfrigérant 700 sous forme gazeuse à haute pression et haute température, en sortie du compresseur 200, est admis dans le condenseur interne 301, qui selon ce mode de fonctionnement est actif.

Pour cela, le dispositif d'obturation 31 est en position ouverte, comme cela est représenté par des pointillés sur les figures 2 à 5, de manière à ce que le condenseur interne 301 soit exposé à un flux d'air A traversant l'installation de ventilation, de chauffage et/ou de climatisation pour être envoyé en direction de l'habitacle du véhicule 2. Durant son passage le long du condenseur interne 301, le fluide réfrigérant 700 cède ses calories au flux d'air A traversant le condenseur interne 301, de manière à fournir un flux d'air A chaud en direction de l'habitacle.

Lors de son passage dans le condenseur interne 301, le fluide réfrigérant 700 subit un premier changement de phase et se transforme en liquide. Lors de ce changement de phase, la pression du fluide réfrigérant 700 reste constante et sa température diminue, le fluide réfrigérant 700 cédant une partie de sa chaleur au flux d'air A traversant le condenseur interne 301.

Le fluide réfrigérant 700, essentiellement sous forme liquide à la sortie du condenseur interne 301, est ensuite acheminé dans le premier organe de détente 401, avec le passage vers la branche 802 fermé par la première vanne de contrôle du débit 61. Le fluide réfrigérant 700 subit alors une détente permettant d'abaisser sa pression ce qui a pour résultat l'obtention d'un fluide réfrigérant 700 à l'état liquide et à basse température.

Le fluide réfrigérant 700 est ensuite acheminé vers l'échangeur thermique 36. Le fluide réfrigérant 700 étant ici sous forme liquide, cet échangeur thermique 36 se comporte comme un évaporateur 600, dans lequel le fluide réfrigérant 700 échange ses calories avec un milieu environnant l'échangeur thermique 36 et notamment avec le flux d'air extérieur E. Il est à noter que, le mode pompe à chaleur du circuit 1001 est généralement utilisé lorsque le milieu extérieur est froid, ainsi le fluide réfrigérant 700, bien que devenu gazeux, reste à basse température en sortie de l'échangeur thermique 36.

Selon un premier exemple de mise en oeuvre du mode pompe à chaleur, une partie du fluide réfrigérant 700, en sortie de l'échangeur thermique 36, est acheminé vers la branche de refroidissement 800 qui alimente l'échangeur de chaleur 900 dédié au refroidissement du dispositif de connexion électrique 10 précédemment décrit et l'autre partie du fluide réfrigérant 700 est acheminée directement vers le compresseur 200 en passant par la branche retour 806, avec la deuxième vanne de contrôle du débit 62 en position ouverte.

La partie du fluide réfrigérant 700 passant par la branche de refroidissement 800, sous forme gazeuse et à basse température, échange alors des calories avec une partie du dispositif de connexion électrique 10 ou avec la totalité du dispositif de connexion électrique 10, selon la forme que prend l'échangeur de chaleur 900 dédié au refroidissement du dispositif de connexion électrique 10. Au terme de cet échange de calories, le fluide réfrigérant 700 est ensuite réacheminé vers le compresseur 200 pour un nouveau cycle.

Selon un deuxième exemple de mise en oeuvre du mode pompe à chaleur et afin de refroidir plus efficacement le dispositif de connexion électrique 10, la deuxième vanne de contrôle du débit 62 située sur la branche retour 806 est en position fermée. Ainsi, la totalité du fluide réfrigérant 700, en sortie de l'échangeur thermique 36, est acheminé vers la branche de refroidissement 800 qui alimente l'échangeur de chaleur 900 dédié au refroidissement du dispositif de connexion électrique 10 précédemment décrit.

Il est à noter que la branche de refroidissement 800 est équipée de la quatrième vanne de contrôle du débit 64 permettant d'interrompre le refroidissement du dispositif de connexion électrique 10. En effet, durant le roulage du véhicule automobile 2, ou durant une phase de démarrage, il n'est pas nécessaire de refroidir le dispositif de connexion électrique 10. Dans ce cas, le fluide réfrigérant 700 en sortie de l'échangeur thermique 36 est directement acheminé vers le compresseur 200 par la branche retour 806, dont la deuxième vanne de contrôle du débit 62 est en position ouverte.

Selon ce mode de fonctionnement en pompe à chaleur, l'accès à l'évaporateur interne 601 situé sur la branche de climatisation 804 est désactivé en positionnant la troisième vanne de contrôle du débit 63 située sur cette branche 804 en position fermée. Toutefois, selon un mode de déshumidification, la troisième vanne de contrôle du débit 63 est mise en position ouverte de manière à capter l'humidité du flux d'air A circulant dans l'installation de ventilation, chauffage et/ou climatisation avant son chauffage par le condenseur interne 301. En effet, il est à préciser que selon le sens du flux d'air A circulant dans l'installation de ventilation, chauffage et/ou climatisation, le condenseur interne 301 est disposé en aval de l'évaporateur interne 601.

Afin que le circuit 1001 de fluide réfrigérant 700 soit aussi bien adapté au mode climatisation qu'au mode pompe à chaleur, on comprend que l'installation de ventilation, de chauffage et/ou de climatisation, avec laquelle le circuit 1001 coopère, et le circuit 1001 lui-même, comprennent des vannes deux voies, des vannes trois voies, des conduits de circulation pour le fluide réfrigérant 700 et un ou plusieurs dispositifs d'obturation 31.

Avantageusement, le circuit 1002, 1003, 1004 de fluide réfrigérant 700 est également agencé pour refroidir la batterie de traction 3 du véhicule automobile 2. Pour cela, un échangeur de chaleur 100 dédié au refroidissement de la batterie de traction 3, appelé échangeur de chaleur additionnel 100, est prévu sur ce circuit, comme cela sera décrit en relation avec les figures 3 à 5.

Un tel échangeur de chaleur additionnel 100 est, d'une part, agencé au plus près de la batterie de traction 3 pour capter ses calories, en formant par exemple un support pour celle-ci, et d'autre part configuré pour faire circuler le fluide réfrigérant 700, en étant muni de tubes de circulation par exemple.

Selon l'exemple de réalisation montré en figure 3, ce deuxième exemple de circuit 1002 de fluide réfrigérant 700 est en tout point identique au circuit 1001 illustré par la figure 2, exceptée la présence de l'échangeur de chaleur additionnel 100 dédié au refroidissement de la batterie de traction 3 qui est disposé sur la branche de refroidissement 800. En d'autres termes, la branche de refroidissement 800 comprend deux échangeurs de chaleur 100, 900 disposés l'un à la suite de l'autre sur cette branche 800. L'échangeur de chaleur additionnel 100 est installé en série de l'échangeur de chaleur 900 dédié au refroidissement du dispositif de connexion électrique 10.

Plus particulièrement, l'échangeur de chaleur additionnel 100 est situé en amont de l'échangeur de chaleur 900 dédié au refroidissement du dispositif de connexion électrique 10, selon le sens de circulation du fluide réfrigérant 700 dans la branche de refroidissement 800. Ainsi, que ce soit lors de la charge de la batterie de traction 3 ou du roulage, la batterie de traction 3 est refroidie avant que le dispositif de connexion électrique 10 ne soit refroidi. Cet exemple de réalisation présente l'avantage de ne pas avoir à ajouter de vanne de contrôle du débit ou d'organe de détente pour le refroidissement de la batterie de traction 3, par rapport au circuit 1001 illustré par la figure 2.

Un autre avantage de ce deuxième exemple de circuit 1002 réside dans l'optimisation de la durée de vie du compresseur 200. En effet, lors de la charge de la batterie de traction 3, la température moyenne du dispositif de connexion électrique 10 est nettement supérieure à la température moyenne de la batterie de traction 3. Par conséquent, placer le refroidissement du dispositif de connexion électrique 10 en aval du refroidissement de la batterie de traction 3 permet d'optimiser la vaporisation du fluide réfrigérant 700 en sortie de l'échangeur de chaleur 900 dédié au refroidissement du dispositif de connexion électrique 10. Ainsi, la part gazeuse du fluide réfrigérant 700 se dirigeant vers le compresseur 200 est maximisée. De plus, cela permet d'améliorer l'efficacité de l'échangeur de chaleur additionnel 100 en s'assurant que le fluide réfrigérant 700 circulant en son sein soit exclusivement ou quasiment exclusivement sous forme liquide.

Bien entendu, en fonction de l'agencement du véhicule automobile 2, il pourrait être prévu de placer l'échangeur de chaleur 900 dédié au refroidissement du dispositif de connexion électrique 10 en amont de l'échangeur de chaleur additionnel 100 dédié au refroidissement de la batterie de traction 3, l'amont étant entendu selon le sens de circulation du fluide réfrigérant 700 dans la branche de refroidissement 800.

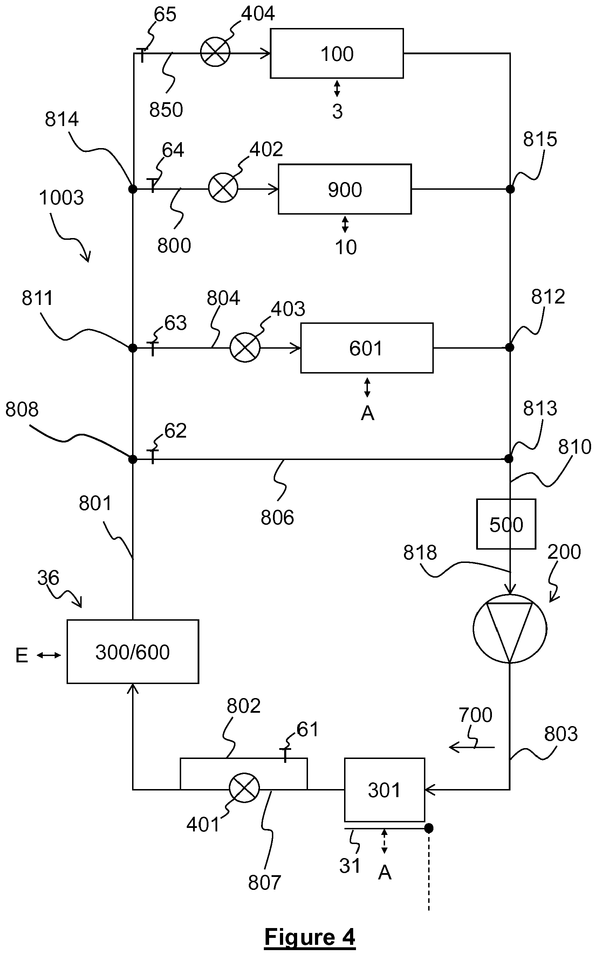

Selon l'exemple de réalisation montré en figure 4, ce troisième exemple de circuit 1003 est en tout point identique au circuit 1001 illustré par la figure 2, exceptée la présence d'une branche de traitement thermique 850 comprenant un échangeur de chaleur additionnel 100 dédié au refroidissement de la batterie de traction 3. En d'autres termes, l'échangeur de chaleur 900 dédié au refroidissement du dispositif de connexion électrique 10 est installé en parallèle de l'échangeur de chaleur additionnel 100. On notera que l'échangeur de chaleur additionnel 100 est également installé en parallèle de l'évaporateur interne 601.

La branche de traitement thermique 850 est disposée entre le condenseur 300 et le compresseur 200, en parallèle de la branche de refroidissement 800 et de la branche de climatisation 804 comprenant l'évaporateur interne 601. Plus précisément, la branche de traitement thermique 850 s'étend entre le quatrième noeud 814 et le cinquième noeud 815.

Il est à noter que pour contrôler une circulation de fluide réfrigérant 700 dans la branche de traitement thermique 850, celle-ci est équipée d'une vanne de contrôle du débit, appelée cinquième vanne de contrôle du débit 65, et d'un organe de détente, appelé quatrième organe de détente 404. Ces deux éléments sont situés en amont de l'échangeur de chaleur additionnel 100. De préférence, la cinquième vanne de contrôle du débit 65 est située en amont du quatrième organe de détente 404.

L'avantage d'un tel circuit 1003 par rapport au circuit 1002 précédent réside dans la réduction des pertes de charge sur la branche basse pression 810, 818 située directement en amont du compresseur 200.

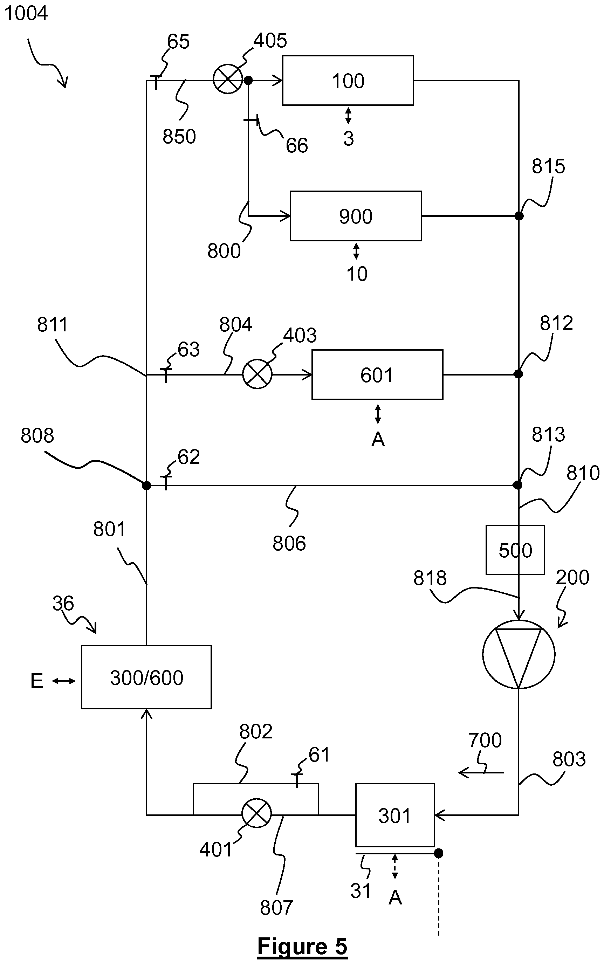

Un quatrième exemple de circuit 1004, illustré par la figure 5, montre que la branche de de traitement thermique 850 dédiée au refroidissement de la batterie de traction 3, comprend une dérivation formant la branche de refroidissement 800 dédiée au refroidissement du dispositif de connexion électrique 10. En d'autres termes, la branche de refroidissement 800 est une dérivation de la branche 850 comportant l'échangeur de chaleur additionnel 100. L'échangeur de chaleur 900 dédié au refroidissement du dispositif de connexion électrique est ici en parallèle de l'échangeur de chaleur 100 dédié au traitement thermique de la batterie de traction 3.

Afin de contrôler la circulation de fluide réfrigérant dans la branche de refroidissement 800 dédiée au refroidissement du dispositif de connexion électrique 10 montée en dérivation, cette dernière est équipée d'une vanne de contrôle du débit, appelée sixième vanne de contrôle du débit 66. Avantageusement, la dérivation est située en aval d'un organe de détente, appelé cinquième organe de détente 405, qui est situé sur la branche de traitement thermique 850. Bien entendu, la dérivation pourrait être située en amont du cinquième organe de détente 405. Dans ce cas, la branche de refroidissement 800 du dispositif de connexion électrique 10 comprendrait son propre organe de détente situé, par exemple, en aval de la sixième vanne de contrôle du débit 66.

Le principal avantage de ce quatrième exemple de circuit 1004 réside dans la possibilité de pouvoir connecter la branche de refroidissement 800 dédiée au refroidissement du dispositif de connexion électrique 10 sur un circuit de fluide réfrigérant 700 et de refroidissement de batterie de traction 3 déjà existant. Ainsi, cela permet également de pouvoir dissocier simplement le refroidissement d'éléments électriques, tels que la batterie de traction 3 et le dispositif de connexion 10, du refroidissement dédié à l'habitacle du véhicule. Pour ce faire, une unique vanne 60 contrôle la circulation du fluide réfrigérant dans la branche additionnelle 850 et dans la branche de refroidissement 800 dédiée au traitement thermique du dispositif de connexion 10.

Quel que soit l'exemple de réalisation retenu, et quel que soit le raccordement de la branche de refroidissement 800 dédiée au dispositif de connexion 10, l'invention permet de réaliser un échange de chaleur permettant d'améliorer la charge de la batterie d'un véhicule automobile 2. Par l'utilisation d'un circuit de fluide réfrigérant 700 disponible sur le véhicule pour alimenter une telle branche de refroidissement 800, l'invention permet une intégration aisée à un véhicule automobile dans lequel les contraintes d'encombrement sont fortes. De plus, en intégrant le refroidissement de la batterie de traction elle-même, ce circuit participe à l'amélioration de l'autonomie cette batterie.

L'invention ne saurait toutefois se limiter aux moyens et configurations décrits et illustrés, et elle s'applique également à tous moyens, ou toutes configurations, équivalent(e)s et à toutes combinaisons de tels moyens et/ou configurations. En effet, si l'invention a été ici décrite et illustrée selon différentes variantes de réalisation mettant en oeuvre chacune séparément un agencement particulier, il va de soi que ces agencements présentés peuvent être combinées sans que cela nuise à l'invention.

## Revendications

1. Circuit (1001, 1002, 1003, 1004) d'un fluide réfrigérant (700) de véhicule (2) comprenant :
- un compresseur (200) destiné à élever la pression du fluide réfrigérant (700),
- un condenseur (300, 301), situé en aval du compresseur (200) selon un sens de circulation du fluide réfrigérant (700) dans le circuit (1001, 1002, 1003, 1004),
- un organe de détente (401, 402, 403, 404, 405), situé en aval du condenseur (300, 301), destiné à abaisser la pression du fluide réfrigérant (700),
- un évaporateur (600, 601), situé en aval de l'organe de détente (401, 402, 403, 404, 405),
**caractérisé en ce qu'**il comprend un échangeur de chaleur (900) dédié au refroidissement d'une prise de charge (12) située sur le véhicule et/ou de la connectique située sur le véhicule (2) reliant une source électrique et la batterie (3) à charger.

2. Circuit selon la revendication 1, **caractérisé en ce que** l'échangeur de chaleur (900) dédié au refroidissement d'une prise de charge (12) située sur le véhicule et/ou de la connectique située sur le véhicule (2) reliant une source électrique et la batterie (3) à charger est configuré pour réaliser un échange thermique entre le fluide réfrigérant (700) et la prise de charge (12) située sur le véhicule et/ou la connectique située sur le véhicule (2) reliant une source électrique et la batterie (3) à charger.

3. Circuit selon la revendication 1 ou 2, **caractérisé en ce qu'**il comprend une branche de refroidissement (800) qui comporte l'échangeur de chaleur (900) dédié au refroidissement d'une prise de charge (12) située sur le véhicule et/ou de la connectique située sur le véhicule (2) reliant une source électrique et la batterie (3) à charger, ladite branche de refroidissement (800) s'étendant dans une portion basse pression connectée au condenseur (300, 301) et au compresseur (200).

4. Circuit selon la revendication précédente, **caractérisé en ce que** la branche de refroidissement (800) comprend une vanne de contrôle du débit (61, 62, 63, 64, 65, 66) située entre le condenseur (300, 301) et l'échangeur de chaleur (900) dédié au refroidissement d'une prise de charge (12) située sur le véhicule et/ou de la connectique située sur le véhicule (2) reliant une source électrique et la batterie (3) à charger.

5. Circuit selon la revendication 3 ou 4, **caractérisé en ce que** la branche de refroidissement (800) s'étend en parallèle d'une branche dite de climatisation (804) comprenant l'évaporateur (600, 601).

6. Circuit selon l'une quelconque des revendications précédentes, **caractérisé en ce que** la branche de refroidissement (800) comprend un organe de détente (401, 402, 403, 404, 405), dit deuxième organe de détente (402), situé entre le condenseur et l'échangeur de chaleur dédié au refroidissement d'une prise de charge (12) située sur le véhicule et/ou de la connectique située sur le véhicule (2) reliant une source électrique et la batterie (3) à charger.

7. Circuit selon l'une quelconque des revendications précédentes, **caractérisé en ce qu'**il comprend un deuxième échangeur de chaleur (100) destiné à un refroidissement d'une batterie (3) de traction du véhicule (2).

8. Circuit selon la revendication précédente prise en combinaison avec la revendication 3 **caractérisé en ce qu'**il comprend une branche de traitement thermique (850) comportant le deuxième échangeur de chaleur (100), ladite branche de traitement thermique (850) étant disposée en parallèle de la branche de refroidissement (800).

9. Circuit selon la revendication 7 prise en combinaison avec la revendication 3, **caractérisé en ce qu'**il comprend une branche de traitement thermique (850) comportant le deuxième échangeur de chaleur (100), la branche de refroidissement (800) formant une dérivation de ladite branche de traitement thermique (850).

10. Circuit selon la revendication 7 prise en combinaison avec la revendication 3, **caractérisé en ce que** l'échangeur de chaleur (900) dédié au refroidissement du dispositif de connexion (10) est disposé en série du deuxième échangeur de chaleur (100) sur la branche de refroidissement (800).
